# EUROPÄISCHE PATENTSCHRIFT

(11) **EP 1 885 065 B1**
(45) Veröffentlichungstag und Bekanntmachung des Hinweises auf die Patenterteilung: **12.10.2011**
(21) Anmeldenummer: 06015722.9
(22) Anmeldetag: 27.07.2006
(51) Int. Cl.: H03K 17/95

(54) **Induktiver Näherungsschalter und Verfahren zu dessen Betrieb**
Inductive proximity switch and method for its operation
Commutateur de proximité inductif et procédé pour son fonctionnement

(43) Veröffentlichungstag der Anmeldung: 06.02.2008
(73) Patentinhaber: Pepperl + Fuchs GmbH, 68307 Mannheim (DE)
(72) Erfinder: Kühn, Thomas, 68219 Mannheim (DE)
(74) Vertreter: Schiffer, Axel Martin

(56) Entgegenhaltungen:
- EP-A1- 0 169 582
- EP-A2- 0 228 019
- DE-A1- 4 427 990
- DE-A1- 10 004 718
- DE-A1- 19 834 071
- YUNQIANG WANG ET AL: "MATERIALUNABHAENGIGES MESSEN DES ABSTANDES VON METALLEN MIT INDUKTIVEN NAEHERUNGSSENSOREN" TECHNISCHES MESSEN TM, R.OLDENBOURG VERLAG. MUNCHEN, DE, Bd. 62, Nr. 12, Dezember 1995 (1995-12), Seiten 470-476, XP000550485 ISSN: 0171-8096

## Beschreibung

Die vorliegende Erfindung betrifft einen induktiven Näherungsschalter nach dem Oberbegriff des Anspruchs 1 sowie ein Verfahren zum Betrieb eines induktiven Näherungsschalters nach dem Oberbegriff des Anspruchs 7.

Ein solcher Näherungsschalter ist beispielsweise aus DE 198 34 071 und DE 41 20 806 bekannt und weist einen Oszillator mit einem Schwingkreis und einem Oszillatorverstärker sowie eine Auswerte- und Steuereinrichtung zum Auswerten einer Impedanz des Schwingkreises und zum Ausgeben eines Schaltsignals auf.

Bei einem gattungsgemäßen Verfahren zum Betrieb eines induktiven Näherungsschalters wird eine Impedanz eines Schwingkreises eines Oszillators als Maß für die Entfernung eines Targets ausgewertet und durch Vergleich der Impedanz mit mindestens einer festzulegenden Schwelle wird ein Schaltsignal gewonnen und ausgegeben.

Es ist bekannt, dass ein durch ein dissipatives Medium, beispielsweise ein metallisches Gehäuse vorbedämpftes Spulensystem bei Annäherung eines Nicht-Eisen-Targets zumindest innerhalb eines bestimmten Target-Abstandsbereich entdämpft werden kann. Grund hierfür sind die im Nicht-Eisen-Target induzierten Wirbelströme, die zu einer Abschwächung der verursachenden Felder führen. Dieser Entdämpfungseffekt, der auf einer überproportionalen Abnahme der Vorbedämpfungsverluste gegenüber einer Zunahme der Targetverluste beruht, ist deshalb bei Metallen mit hoher Leitfähigkeit, beispielsweise Aluminium oder Kupfer, besonders ausgeprägt.

Im Unterschied dazu führt eine Bedämpfung mit hochpermeablen Eisen-Metallen oder Legierungen, beispielsweise Eisen, Nikkel oder Stahl, in der Regel zu einer Verlustzunahme über den gesamten Target-Abstandsbereich. Dieses gegenläufige Verhalten kann genutzt werden, um Nicht-Eisen/Eisen-Schalter mit gleichem Schaltabstand auf beide Materialien zu realisieren.

Eine Schwierigkeit besteht in diesem Zusammenhang darin, dass bei Annäherung eines Nicht-Eisen-Targets auf einen sehr geringen Abstand die Bedämpfungseffekte durch Verluste im Target den beschriebenen Entdämpfungseffekt überwiegen. Die Entdämpfung schlägt also kontinuierlich in eine Bedämpfung um, da die Zunahme der Target-Verluste die Abnahme der Vorbedämpfungsverluste übersteigt.

Hieraus ergeben sich unerwünschte Mehrdeutigkeiten im Hinblick auf das Schaltsignal. In einer bisherigen Lösung bei bekannten Nicht-Eisen/Eisen-Schaltern wird deshalb das Spulensystem so weit in ein Schaltergehäuse versenkt, dass das Target dem Spulensystem nur im Bereich der eindeutig zuzuordnenden Schaltsituationen nähern kann. Damit einher geht jedoch eine unerwünschte Abnahme des nutzbaren Schaltabstands. Außerdem beschränkt sich diese Maßnahme auf nicht bündig einzubauende Schalter.

In DE 44 27 990 A1 ist ein induktiver Näherungssensor gemäß Oberbegriff des Anspruchs 1 zur materialunabhängigen Abstandsmessung beschrieben. Um einen von den Materialeigenschaften des Metallobjekts unabhängigen Schaltpunkt zu erreichen, wird dort zusätzlich die Resonanzfrequenz eines Schwingkreises gemessen.

Gegenstand von EP 0 169 582 A1 ist ein Näherungsschalter, bei dem, um ein Anschwingen aus dem Rauschen zu beschleunigen, die Verstärkung zu Beginn des Anschwingvorgangs erhöht wird.

DE 100 04 718 A1 betrifft einen induktiven Näherungssensor, bei den zur Abstandsbestimmung eines Gegenstands eine Oszillatorfrequenz ausgewertet wird.

In DE 198 34 071 A1 ist ein induktiver Näherungsschalter beschrieben, bei dem eine Messspule unmittelbar hinter einer Stirnseite des Sensorgehäuses angebracht ist.

**Aufgabe** der Erfindung ist, einen induktiven Näherungsschalter zu schaffen, bei dem der gesamte Empfindliychkeitsbereich ausgenutzt werden kann. Außerdem soll ein Verfahren zum Betrieb eines induktiven Näherungsschalters angegeben werden, welches höhere Schaltabstände gestattet.

Diese Aufgabe wird durch den induktiven Näherungsschalter mit den Merkmalen des Anspruchs 1 und durch das Verfahren mit den Merkmalen des Anspruchs 8 gelöst.

Bevorzugte Ausführungsbeispiele des erfindungsgemäßen Näherungsschalters und vorteilhafte Varianten des erfindungsgemäßen Verfahrens sind Gegenstand der abhängigen Ansprüche.

Der induktive Näherungsschalter der oben beschriebenen Art ist erfindungsgemäß dadurch weitergebildet, dass eine Frequenzmesseinrichtung vorhanden ist zum Messen der Schwingungsfrequenz des Oszillators und zum Beseitigen von Mehrdeutigkeiten des Auswerteergebnisses der Auswerte- und Steuereinrichtung.

Das Verfahren der oben angegebenen Art ist erfindungsgemäß dadurch weitergebildet, dass zusätzlich die Frequenz des Oszillators gemessen wird, um Mehrdeutigkeiten bei der Auswertung der Schwingungsamplitude des Oszillators zu beseitigen.

Als Kerngedanke der Erfindung kann angesehen werden, zusätzlich zur Auswertung der Schwingkreisimpedanz oder der Oszillatoramplitude die Frequenz des Oszillators zu messen, um auf diese Weise eine zusätzliche Information zu erhalten. Hierbei wird ausgenutzt, dass eine Bedämpfung des Oszillators mit einem Nicht-Eisen-Target bei sehr geringen Abständen zu einer geringeren Induktivität und damit im Vergleich zu größeren Abständen zu einer höheren Schwingungsfrequenz führt.

Ein wesentlicher Vorteil des erfindungsgemäßen Näherungsschalters und des erfindungsgemäßen Verfahrens ist, dass mit einfachen Mitteln der gesamte Empfindlichkeitsbereich des Sensors ausgenutzt und deshalb höhere Schaltabstände erreicht werden können.

Da die genannten Frequenzunterschiede größenordnungsmäßig im Prozentbereich liegen, kann die eigentliche Frequenzmessung einfach gestaltet sein. Die erfindungsgemäßen Vorteile können deshalb bereits bei einfach aufgebauten Näherungsschaltern kostengünstig realisiert werden.

Grundsätzlich kann der erfindungsgemäße Näherungsschalter mit einem kontinuierlich arbeitenden Oszillator mit zwei getrennten Schaltschwellen für die Oszillatoramplitude, deren Über- beziehungsweise Unterschreitung als Nicht-Eisen- beziehungsweise Eisen-Schaltsignal interpretiert wird, verwirklicht werden. Unter einem kontinuierlich arbeitenden Oszillator soll dabei ein solcher Oszillator verstanden werden, bei dem die Schwingungsamplitude vergleichsweise langsam mit dem Abstand des Targets variiert.

Mit Hilfe einer logischen "Oder"-Verknüpfung der beiden Schaltsignale kann dann die gewünschte Funktion eines materialunabhängig arbeitenden Sensors erhalten werden, sofern die Schwingungsfrequenz als zusätzliche Größe herangezogen wird.

Besonders bevorzugt wird der erfindungsgemäße Näherungsschalter mit Hilfe eines sehr steilen beziehungsweise unstetig arbeitenden Oszillators realisiert, dessen Schwingungszustand sich innerhalb eines sehr kleinen Impedanzbereichs ändert. Mit Hilfe eines solchen Oszillators können auch extrem kleine Änderungen der Schwingkreisimpedanz ausgewertet werden.

Bei einer vorteilhaften Variante des induktiven Näherungsschalters ist der Oszillatorverstärker ein einstellbarer; insbesondere spannungsgesteuerter, Verstärker. Besonders bevorzugt sind hierbei hochlineare Verstärker, bei denen bereits eine kleine Änderung der Resonanzimpedanz auf einen großen Amplitudenhub abgebildet wird. Mit solchen spannungsgesteuerten Verstärkern können sehr definierte Schaltschwellen für den Näherungsschalter eingestellt werden. Durch eine bestimmte beim Oszillatorverstärker eingestellte Verstärkung wird eine Schwelle für die Resonanzimpedanz festgelegt. Bei der der Schwelle entsprechenden Resonanzimpedanz ist deshalb die Amplitudenänderung mit einer Änderung der Impedanz besonders groß. In einem einfachen Auswertungsfall wird dann nur geprüft, ob der Oszillator schwingt oder nicht.

Im Hinblick auf die nachzuweisenden Eisen- und Nicht-Eisen-Metalle ist es erfindungsgemäß der spannungsgesteuerte Oszillatorverstärker auf mindestens zwei verschiedene Verstärkungen einstellbar. Erfindungsgemäß wird der Oszillatorverstärker zwischen zwei genau definierten Verstärkungen umgeschaltet und nach der Umschaltung wird der jeweilige Schwingungszustand des Oszillators bewertet. Die Verstärkungen sind dabei so gewählt, dass eine besonders große Amplitudenänderung gegeben ist, wenn sich ein Nicht-Eisen-Target beziehungsweise ein Eisen-Target durch den Schaltpunkt bewegt. Besonders bevorzugt werden die Schwellen außerdem so gewählt, dass man für Nicht-Eisen-Targets denselben Schaltabstand erhält wie für Eisen-Targets.

Das Auswerten einer Schwingungsamplitude des Oszillators kann bei einer einfachen Ausführungsvariante mit Hilfe eines dem Oszillatorverstärker nachgeschalteten Komparators realisiert werden, wobei zweckmäßig zwischen dem Verstärker und dem Komparator ein Gleichrichter vorgesehen sein kann. Sofern die Schwingungsamplitude über einer eingestellten Komparatorschwelle liegt, oszilliert auch das Ausgangssignal des Komparators als Rechtecksignal mit der jeweiligen Schwingungsfrequenz. Dieses Rechtecksignal kann deshalb sehr einfach zur Frequenzbestimmung verwendet werden.

Die Steuer- und Auswerteeinrichtung kann beispielsweise ein Mikrokontroller sein, in dem auch die Frequenzmesseinrichtung integriert ist.

Die Frequenzmessung kann in grundsätzlich bekannter Weise durchgeführt werden. Besonders einfach kann eine Frequenzbestimmung oder -messung durch Abzählen von Schwingungsperioden, beispielsweise mit Hilfe des Mikrokontrollers, erfolgen.

Die variabel einzustellende Verstärkung des spannungsgesteuerten Oszillatorverstärkers kann auch zur Kompensation von Temperaturvariationen des Schaltabstands benutzt werden. In apparativer Hinsicht ist hierzu zum Ermitteln einer Temperatur der elektronischen Komponenten und zum Kompensieren von Temperaturvariationen des Schaltabstands ein mit dem spannungsgesteuerten Oszillatorverstärker zusammenwirkender Temperaturfühler vorhanden. Als Temperaturfühler kann beispielsweise ein NTC-Netzwerk verwendet werden. Die Funktionalität und Zuverlässigkeit des Näherungsschalters kann bei diesen Varianten auch für Einsatzbereiche mit stark schwankenden Umgebungstemperaturen erheblich verbessert werden.

Ein wesentlicher Vorteil der Erfindung ist, dass der gesamte Empfindlichkeitsbereich des Sensors ausgenutzt und deshalb der Schaltabstand vergrößert werden kann. Bei einer besonders bevorzugten Variante des erfindungsgemäßen Näherungsschalters ist deshalb ein Sensorgehäuse so ausgebildet, dass ein Spulensystem dort bezogen auf die Sensorfläche bündig einbaubar ist.

Um einen Näherungsschalter zu erhalten, der für Nicht-Eisen und Eisen-Targets im Wesentlichen denselben Schaltabstand aufweist, wird zweckmäßig ein Schaltsignal ausgegeben, wenn die Impedanz des Schwingkreises eine untere Schwelle unterschreitet oder eine obere Schwelle überschreitet. Die untere und die obere Schwelle können dabei zweckmäßig in Einlerndurchläufen festgelegt werden.

Ein eindeutiges Schaltsignal und eine Information, ob es sich um ein Eisen- oder ein Nicht-Eisen-Target handelt, erhält man, wenn nacheinander folgende Verfahrensschritte durchgeführt werden:
a) Messen der Schwingungsamplitude bei einer ersten Verstärkung;
b) Setzen des Schaltsignals, falls der Oszillator bei der ersten Verstärkung nicht schwingt und Rückkehr zu Schritt a);
c) Messen der Oszillatorfrequenz, falls der Oszillator bei der ersten Verstärkung schwingt;
d) Setzen des Schaltsignals, falls die gemessene Frequenz in einem festzulegenden Frequenzbereich liegt und Rückkehr zu Schritt a);
e) Messen der Schwingungsamplitude bei einer zweiten Verstärkung, falls die gemessene Frequenz nicht in dem festzulegenden Frequenzbereich liegt;
f) Setzen des Schaltsignals, falls der Oszillator bei der zweiten Verstärkung schwingt und Rückkehr zu Schritt c); und
g) Rückkehr zu Schritt a), falls der Oszillator bei der zweiten Verstärkung nicht schwingt.

Durch die erste Verstärkung wird eine untere Schwelle für die Resonanzimpedanz des Schwingkreises definiert. Entsprechend wird durch die zweite Verstärkung eine obere Schwelle für die Resonanzimpedanz festgelegt.

Bei dem erfindungsgemäßen Näherungsschalter kann neben einem reinen Schaltsignal aufgrund der Zusatzinformation durch die Frequenzmessung grundsätzlich auch ein weiteres Signal ausgegeben werden, welches anzeigt, ob das nachgewiesene Target ein Nicht-Eisen-Target oder ein Eisen-Target ist.

Weitere Vorteile und Merkmale der Erfindung werden nachstehend mit Bezug auf die beigefügten Zeichnungen beschrieben. Hierin zeigen:
- Fig. 1: ein Diagramm, in dem die Änderung der Resonanzimpedanz im fraglichen Abstandsbereich für Nicht-Eisen-Targets und Eisen-Targets aufgetragen ist;
- Fig. 2: ein Blockschaltbild eines erfindungsgemäßen induktiven Näherungsschalters; und
- Fig. 3: ein Flussdiagramm, anhand dessen eine Variante des erfindungsgemäßen Verfahrens erläutert wird.

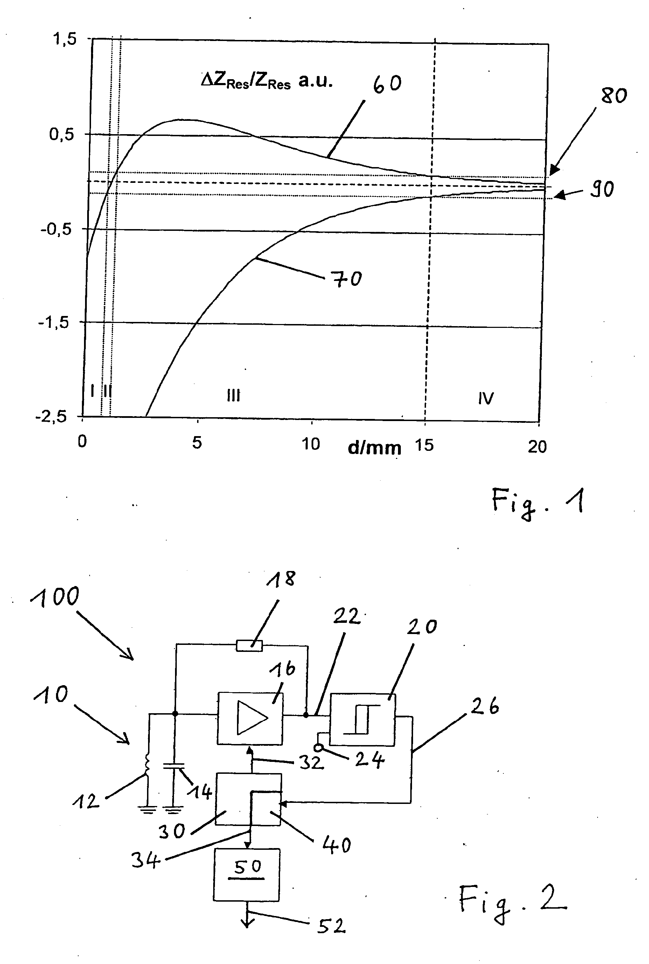

In Fig. 1 ist die relative Änderung der Resonanzimpedanz ΔZ/Z eines Schwingkreises bei Annäherung eines Targets für einen Näherungsschalter mit einem nominalen Schaltabstand d von 15 mm dargestellt. Die zu einen Nicht-Eisen-Target gehörende Kurve trägt die Bezugsziffer 60. Die mit dem Bezugszeichen 70 gekennzeichnete Kurve zeigt den Verlauf der Resonanzimpedanz ΔZ/Z für ein Eisen-Target. Der Schwingkreis ist im gezeigten Beispiel ein Parallelschwingkreis, so dass eine Erhöhung der Resonanzimpedanz Z einer Verlustabnahme oder einer Entdämpfung entspricht und umgekehrt.

Eindeutig ist die Situation nur für ein Nicht-Eisen-Target im Bereich III. Dort ist die Resonanzimpedanz größer als eine obere Schwelle 80. Da dies nur für ein Nicht-Eisen-Target in diesem Abstandsbereich verwirklicht ist, kann eindeutig entschieden werden, dass sich ein Nicht-Eisen-Target näher als der Schaltabstand d an dem Sensor befindet.

Die Bereiche I, II und IV sowie der Bereich III soweit Eisen-Targets nachgewiesen werden sollen, können jedoch nicht allein auf Grundlage der Impedanzmessung unterschieden werden. So wird eine Resonanzimpedanz, die kleiner als die untere Schranke 90 ist, sowohl im Bereich I durch ein Nicht-Eisen-Target als auch im Bereich III durch ein Eisen-Target realisiert. Weiterhin werden Resonanzimpedanzen zwischen der oberen Schwelle 80 und der unteren Schwelle 90 durch ein Nicht-Eisen-Target in den Bereichen II und IV und außerdem durch ein Eisen-Target im Bereich IV verwirklicht.

Der Bereich II, in dem der Schalter schalten müsste, da sich das Target deutlich näher als der Schaltabstand d am Sensor befindet, ist also vom Bereich IV, in dem der Schalter nicht schalten soll, nicht zu unterscheiden. Dies ist extrem unerwünscht.

Die erfindungsgemäße Lösung besteht darin, die reine Impedanzauswertung um eine Messung der Oszillatorfrequenz zu erweitern. Eine Bedämpfung durch ein Nicht-Eisen-Target im Bereich II führt aufgrund der im Target induzierten Wirbelströme zu einer geringeren Induktivität und damit zu einer höheren Schwingungsfrequenz als eine entsprechende Bedämpfung im Bereich IV. Durch Unterscheidung beider Schwingungsfrequenzen lässt sich damit trotz identischer Resonanzimpedanzen eine eindeutige Aussage ableiten, ob eine Bedämpfung im Bereich II oder IV vorliegt. Eine Versenkung des Spulensystems ist deshalb nicht mehr erforderlich und es können auch bündig oder jedenfalls im Wesentlichen bündig einbaubare Schalter realisiert werden.

Da die Schwingungsfrequenzen des Oszillators in den zu unterscheidenden Bereichen deutlich unterschiedlich sind, der Frequenzunterschied liegt größenordnungsmäßig im Prozentbereich, ist eine hochpräzise oder hoch auflösende Bestimmung der Schwingungsfrequenz nicht notwendig. Es kann vielmehr eine vergleichsweise grobe Trennung von zwei Frequenzen erfolgen und der Aufwand zur Frequenzmessung kann gering gehalten werden. Beispielsweise kann es ausreichend sein, über ein genügend großes Zeitintervall die Schwingungsperioden abzuzählen.

Ein mögliches Ausführungsbeispiel eines erfindungsgemäßen induktiven Näherungsschalters 100 ist in Fig. 2 dargestellt. Als wesentliche Komponenten weist der dort gezeigte Näherungsschalter 100 einen Schwingkreis 10, einen Oszillatorverstärker 16, einen Komparator 20, einen Mikrokontroller 30 als Auswerte- und Steuereinrichtung mit Frequenzmesseinrichtung 40 sowie einen Ausgangsverstärker 50 auf.

Der Schwingkreis 10 ist ein Parallelschwingkreis und wird durch eine Induktivität 12 und eine Kapazität 14 gebildet. Zusammen mit dem über einen Widerstand 18 rückgekoppelten Oszillatorverstärker 16 bildet der Schwingkreis 10 einen Oszillator. Der Oszillatorverstärker 16 ist ein spannungsgesteuerter Verstärker, der über das Spulensystem beziehungsweise den Schwingkreis 10 mitgekoppelt ist.

Die Schaltschwelle des Oszillators wird durch die Verstärkung des Oszillatorverstärkers 16 bestimmt. Diese wiederum wird durch eine Steuerspannung definiert, die vom Mikrokontroller 30 als Auswerte- und Steuereinrichtung generiert und dem Verstärker 16 über einen Eingang 32 zugeführt wird. Hierzu können beispielsweise im Mikrokontroller 30 ein Digital-Analog-Wandler oder eine Pulsweitenmodulations-Quelle mit Tiefpass vorgesehen sein. Eine Umschaltung zwischen den beiden Schwellen zur Ermittlung des Bedämpfungszustands und demnach zur Ermittlung der Resonanzimpedanz des Schwingkreises 10 erfolgt durch entsprechendes Umschalten der Steuerspannung des Verstärkers 16. Dieselbe Steuerspannung kann auch zusätzlich zur Nachführung des Schaltabstands d bei Temperaturvariationen verwendet werden.

Ein Ausgangssignals des Verstärkers 16 wird einem ersten Eingang 22 eines Komparators 20, bei dem es sich im gezeigten Beispiel um einen Schmitt-Trigger handelt, zugeführt. An einem zweiten Eingang 24 des Komparators 20 wird eine Referenzspannung angelegt, die ebenfalls im Mikrokontroller 30 generiert werden kann. Schwingt nun der Oszillator mit einer durch die am Eingang 24 des Komparators 20 anliegende Referenzspannung bestimmten Amplitude, treten am Ausgang 26 des Komparators 20 Rechteckimpulse auf, die einerseits eine Überprüfung des Schwingungszustands ermöglichen, andererseits eine Bestimmung der Frequenz zulassen. Der Ausgang 26 des Komparators 20 ist hierzu mit dem Mikrokontroller 30 verbunden.

In dem Mikrokontroller 30 ist die erfindungsgemäß vorgesehen Frequenzmesseinrichtung 40 integriert, die in einem einfachen Ausführungsbeispiel die von dem Komparator 20 abgegebenen Rechteckpulse über ein hinreichend großes Zeitintervall zählt.

In dem Mikrokontroller 30 wird sowohl die Messinformation im Hinblick auf die Resonanzimpedanz, also die Oszillatoramplitude, als auch die Frequenzinformation verarbeitet und abhängig hiervon wird am Ausgang 34 des Mikrokontrollers 40 ein Signal bereitgestellt. Dieses Signal wird einem Endverstärker 50 zugeführt, der hieraus das eigentliche vom Sensor 100 abgegebene Schaltsignal 52 generiert. Darüber hinaus kann auch ein weiteres Signal vom Mikrokontroller 30 abgegeben werden, mit welchem angezeigt wird, ob es sich um ein Nicht-Eisen-Target oder ein Eisen-Target handelt. Möglich ist dies jedenfalls in den Bereichen II und III.

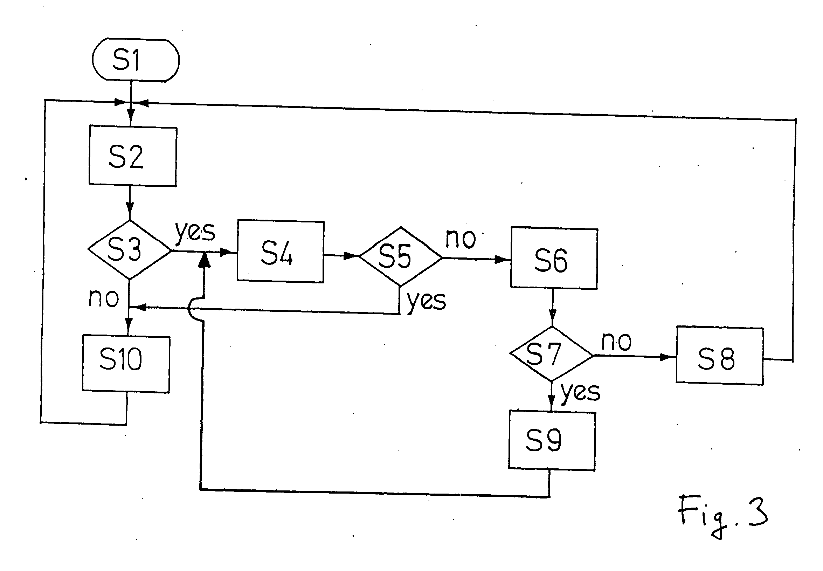

Ein Verfahrensbeispiel, wie die beschriebenen Messinformationen im Mikrokontroller 30 ausgewertet werden können und wie der Messablauf insgesamt gesteuert werden kann, wird anhand von Fig. 3 erläutert.

Ausgehend vom Start S1 des Flussdiagramms wird zunächst in Schritt S2 eine Messung bei einer ersten Verstärkung des Oszillatorverstärkers 16 durchgeführt, die der unteren Schwelle 90 im Diagramm aus Fig. 1 entspricht. Sodann wird in Schritt S3 geprüft, ob der Oszillator schwingt, ob also die Resonanzimpedanz des Schwingkreises größer als die untere Schwelle ist. Wenn dies der Fall ist, wird in Schritt S4 eine Frequenzmessung durchgeführt und anschließend wird in Schritt S5 geprüft, ob die Frequenz in dem zum Bereich II aus Fig. 1 gehörenden Frequenzbereich gehört. Wenn dies der Fall ist, wenn sich also das Target im Bereich II, das heißt wesentlich näher als der Schaltabstand am Sensor befindet, wird im Schritt S10 der Schalter betätigt, und der Ablauf kehrt zu Schritt S2 zurück. Wenn die Prüfung in Schritt S3 jedoch ergibt, dass der Oszillator nicht schwingt, wird in Schritt S10 der Schalter betätigt, da man sich im Bereich III auf der zu einem Eisen-Target gehörenden Kurve 70 befinden muss.

Entspricht die in Schritt S5 bestimmte Frequenz nicht der zum Bereich II und einem Nicht-Eisen-Target gehörenden Frequenz, erfolgt ein Übergang zu Schritt S6, in dem eine Messung der Oszillatoramplitude bei einer zweiten Schwelle durchgeführt wird, die der oberen Schwelle 80 in dem in Fig. 1 gezeigten Diagramm entspricht. Anschließend erfolgt in Schritt S7 wiederum eine Überprüfung, ob der Oszillator schwingt. Wenn dies der Fall ist, befindet man sich im Bereich III und es handelt sich um ein Nicht-Eisen-Target und entsprechend wird in Schritt S9 der Schalter betätigt. Anschließend erfolgt ein Übergang zu Schritt S4 und eine erneute Messung der Schwingungsfrequenz.

Ergibt die Überprüfung in Schritt S7, dass der Oszillator nicht schwingt, bleibt der Schalter in Schritt S8 unbetätigt und es erfolgt ein Übergang zum Beginn des Ablaufs in Schritt S2.

Der hier beschriebene Ablauf ist grundsätzlich dahingehend erweiterbar, dass auch der Bereich I für ein Nicht-Eisen-Target vom Bereich III für ein Eisen-Target eindeutig unterschieden werden kann.

Mit der vorliegenden Erfindung wird ein neuartiger induktiver Näherungsschalter bereitgestellt, bei dem mit einfachen Mitteln eine deutlich höhere Funktionalität erzielt wird. Durch eine kombinierte Auswertung sowohl von Impedanz- als auch von Frequenzänderungen ist bei dem erfindungsgemäßen Näherungsschalter ein Erkennen einer Annäherung oder des Vorhandenseins sowie außerdem eine Unterscheidung von Nicht-Eisen-Targets und Eisen-Targets möglich. Unter Eisen-Metallen werden hier insbesondere Eisen, Nickel und Stahl verstanden. Insbesondere können induktive Näherungsschalter aufgebaut werden, welche für Nicht-Eisen-Targets und Eisen-Targets denselben Schaltabstand d aufweisen.

Durch die erfindungsgemäße kombinierte Auswertung von Impedanz- und Frequenzänderungen kann im Prinzip der gesamte Empfindlichkeitsbereich des induktiven Näherungsschalters zum Einsatz kommen und es können insbesondere Sensoren geschaffen werden, bei denen das Spulensystem bezogen auf eine äußere Sensorfläche bündig eingebaut ist.

Ein wesentlicher Vorteil eines solchen Aufbaus ist insbesondere, dass höhere Schaltabstände erreicht werden können.

## Patentansprüche

1. Induktiver Näherungsschalter
mit einem Oszillator mit einem Schwingkreis (10) und einem Oszillatorverstärker (16),
mit einer Auswerte- und Steuereinrichtung (30) zum Auswerten einer Impedanz (Z) des Schwingkreises (10) und zum Ausgeben eines Schaltsignals, und
mit einer Frequenzmesseinrichtung (40) zum Messen der Schwingungsfrequenz des Oszillators und zum Beseitigen von Mehrdeutigkeiten des Auswerteergebnisses der Auswerte- und Steuereinrichtung (30),
**dadurch gekennzeichnet,**
**dass** zum Beurteilen eines Schwingungszustands des Oszillators bei zwei getrennten Schaltschwellen der Oszillatorverstärker (16) zwischen mindestens zwei verschiedenen Verstärkungen umschaltbar ist.

2. Näherungsschalter nach Anspruch 1,
**dadurch gekennzeichnet,**
**dass** der Oszillatorverstärker (16) ein spannungsgesteuerter Verstärker ist.

3. Näherungsschalter nach einem der Ansprüche 1 oder 2,
**dadurch gekennzeichnet,**
**dass** zum Auswerten einer Schwingungsamplitude des Oszillators ein dem Oszillatorverstärker (16) nachgeschalteter Komparator (20) vorhanden ist.

4. Näherungsschalter nach einem der Ansprüche 1 bis 3,
**dadurch gekennzeichnet,**
**dass** die Frequenzmessung durch Abzählen von Schwingungsperioden in einem Mikrokontroller (30) erfolgt.

5. Näherungsschalter nach einem der Ansprüche 1 bis 4,
**dadurch gekennzeichnet,**
**dass** ein Sensorgehäuse so ausgebildet ist, dass ein Spulensystem dort bezogen auf die Sensorfläche bündig einbaubar ist.

6. Näherungsschalter nach einem der Ansprüche 1 bis 5,
**dadurch gekennzeichnet,**
**dass** zum Ermitteln einer Temperatur der elektronischen Komponenten und zum Kompensieren von Temperaturvariationen ein mit dem Oszillatorverstärker (16) zusammenwirkender Temperaturfühler, insbesondere ein NTC-Netzwerk, vorhanden ist.

7. Verfahren zum Betrieb eines induktiven Näherungsschalters nach einem der Ansprüche 1 bis 6,
bei dem eine Impedanz (Z) des Schwingkreises (10) eines Oszillators als Maß für die Entfernung eines Targets ausgewertet wird,
bei dem durch Vergleich der Impedanz (Z) des Schwingkreises (10) mit mindestens einer festzulegenden Schwelle ein Schaltsignal gewonnen und ausgegeben wird,
und bei dem zusätzlich die Frequenz des Oszillators gemessen wird, um Mehrdeutigkeiten bei der Auswertung der Impedanz (Z) des Schwingkreises (10) zu beseitigen,
**dadurch gekennzeichnet,**
**dass** der Oszillatorverstärker zwischen zwei genau definierten Verstärkungen umgeschaltet wird und
**dass** nach der Umschaltung ein jeweiliger Schwingungszustand des Oszillators bewertet wird.

8. Verfahren nach Anspruch 7,
**dadurch gekennzeichnet,**
**dass** ein Schaltsignal ausgegeben wird, wenn die Impedanz (Z) eine untere Schwelle (90) unterschreitet oder eine obere Schwelle (80) überschreitet.

9. Verfahren nach einem der Ansprüche 7 oder 8,
**dadurch gekennzeichnet,**
**dass** die untere Schwelle (90) und/oder die obere Schwelle (80) in Einlerndurchläufen festgelegt werden.

10. Verfahren nach einem der Ansprüche 7 bis 9,
**dadurch gekennzeichnet,**
**dass** als Oszillatorverstärker (16) ein spannungsgesteuerter Verstärker verwendet wird.

11. Verfahren nach einem der Ansprüche 7 bis 10,
**dadurch gekennzeichnet,**
**dass** eine variabel einzustellende Verstärkung des Oszillatorverstärkers (16) zur Kompensation von Temperaturvariationen des Schaltabstands (d) benutzt wird.

12. Verfahren nach einem der Ansprüche 7 bis 11,
**dadurch gekennzeichnet,**
**dass** nacheinander folgende Verfahrensschritte durchgeführt werden:
a) Messen der Schwingungsamplitude bei einer ersten Verstärkung (S2);
b) Setzen des Schaltsignals, falls der Oszillator bei der ersten Verstärkung nicht schwingt (S10) und Rückkehr zu Schritt a);
c) Messen der Oszillatorfrequenz, falls der Oszillator bei der ersten Verstärkung schwingt (S4);
d) Setzen des Schaltsignals, falls die gemessene Frequenz in einem festzulegenden Frequenzbereich liegt (S10) und Rückkehr zu Schritt a);
e) Messen der Schwingungsamplitude bei einer zweiten Verstärkung, falls die gemessene Frequenz nicht in dem festzulegenden Frequenzbereich liegt (S6);
f) Setzen des Schaltsignals, falls der Oszillator bei der zweiten Verstärkung schwingt (S9) und Rückkehr zu Schritt c); und
g) Rückkehr zu Schritt a), falls der Oszillator bei der zweiten Verstärkung nicht schwingt (S8).

## Claims

1. Inductive proximity switch,
having an oscillator with a resonant circuit (10) and an oscillator amplifier (16) with an evaluating and control device (30) for evaluating an impedance (Z) of the resonant circuit (10) and for outputting a switching signal, and
with a frequency measuring device (40) for measuring the oscillation frequency of the oscillator and for eliminating ambiguities of the evaluation result of the evaluating and control device (30),
**characterized in**
**that** in the case of two separated switching thresholds the oscillator amplifier (16) can be set to at least two different gains for evaluating an oscillation state of the oscillator.

2. Proximity switch according to claim 1,
**characterized in**
**that** the oscillator amplifier (16) is a voltage-controlled amplifier.

3. Proximity switch according to one of the claims 1 or 2,
**characterized in**
**that** a comparator (20) downstream of the oscillator amplifier (16) is provided for evaluating an oscillation amplitude of the oscillator.

4. Proximity switch according to one of the claims 1 to 3,
**characterized in**
**that** the frequency measurement takes place by counting the oscillation periods in a microcontroller (30).

5. Proximity switch according to one of the claims 1 to 4,
**characterized in**
**that** a sensor housing is constructed in such a way that, relative to the sensor surface, a coil system can be installed in flush manner.

6. Proximity switch according to one of the claims 1 to 5,
**characterized in**
**that** for determining a temperature of the electronic components and for compensating temperature variations a temperature sensor, particularly a NTC network, cooperating with the oscillator amplifier (16) is provided.

7. Method for operating an inductive proximity switch according to one of the claims 1 to 6,
in which an impedance (Z) of the resonant circuit (10) of an oscillator is evaluated as a measure for the distance of a target
in which through comparing impedance (Z) of resonant circuit (10) with at least one threshold to be fixed a switching signal is obtained and outputted, and
in which additionally the frequency of the oscillator is measured in order to eliminate ambiguities in the evaluation of the impedance (Z) of the resonant circuit (10). **characterized in**
**that** the oscillator amplifier is switch over to two exactly predefined gains, and
**that** after the switch-over an respective oscillation state of the oscillator is evaluated.

8. Method according to claim 7,
**characterized in**
**that** a switching signal is outputted if the impedance (Z) drops below a lower threshold (90) or exceeds an upper threshold (80).

9. Method according to one of the claims 7 or 8,
**characterized in**
**that** the lower threshold (90) and/or the upper threshold (80) are established in learning sweeps.

10. Method according to one of the claims 7 to 9,
**characterized in**
**that** a voltage-controlled amplifier is used as oscillator amplifier (16).

11. Method according to one of the claims 7 to 10,
**characterized in**
**that** for compensating the temperature variations of the switching interval (d) use is made of a gain of oscillator amplifier (16) which can be set in a variable manner.

12. Method according to one of the claims 7 to 11,
**characterized in**
**that** the following method steps are successively performed:
a) measuring the oscillation amplitude at a first gain (S2);
b) setting the switching signal if during the first gain the oscillator does not oscillate (S10) and return to step a);
c) measuring the oscillator frequency if the oscillator oscillates during the first gain (S4);
d) setting the switching signal if the measured frequency is in a frequency range to be fixed (S10) and return to step a);
e) measuring the oscillation amplitude at a second gain, if the measured frequency is not in the frequency range to be fixed (S6);
f) setting the switching signal if the oscillator oscillates during the second gain (S9) and return to step c); and
g) return to step a), if the oscillator does not oscillate during the second gain (S8).

## Revendications

1. Commutateur de proximité inductif
avec un oscillateur comprenant un circuit oscillant (10) et un amplificateur (16) d'oscillateur,
avec un dispositif (30) d'analyse et de commande pour analyser une impédance (Z) du circuit oscillant (10) et délivrer un signal de commutation, et
avec un dispositif (40) de mesure de fréquence pour mesurer la fréquence d'oscillation de l'oscillateur et pour éliminer des ambiguïtés au niveau du résultat de l'analyse menée par le dispositif (30) d'analyse et de commande,
***caractérisé***
***en ce que******,*** pour évaluer un état oscillatoire de l'oscillateur pour deux seuils de commutation séparés, l'amplificateur (16) d'oscillateur peut être commuté entre au moins deux amplifications différentes.

2. Commutateur de proximité selon la revendication 1,
***caractérisé***
***en ce que*** l'amplificateur (16) d'oscillateur est un amplificateur régulé en tension.

3. Commutateur de proximité selon l'une quelconque des revendications 1 ou 2,
***caractérisé***
***en ce que***, pour analyser une amplitude d'oscillation de l'oscillateur, il est prévu un comparateur (20) placé après l'amplificateur (16) d'oscillateur.

4. Commutateur de proximité selon l'une quelconque des revendications 1 à 3,
***caractérisé***
***en ce que*** la mesure de fréquence est effectuée par comptage de périodes d'oscillation dans un microcontrôleur (30).

5. Commutateur de proximité selon l'une quelconque des revendications 1 à 4,
***caractérisé***
***en ce qu*'**un boîtier de capteur est configuré de telle manière qu'un système de bobine peut y être monté en affleurement par rapport à la surface du capteur.

6. Commutateur de proximité selon l'une quelconque des revendications 1 à 5,
***caractérisé***
***en ce que****,* pour déterminer une température des composants électroniques et compenser des variations de température, il est prévu un capteur de température, en particulier un réseau NTC, coopérant avec l'amplificateur (16) d'oscillateur.

7. Procédé de fonctionnement d'un commutateur de proximité inductif selon l'une quelconque des revendications 1 à 6,
dans lequel une impédance (Z) du circuit oscillant (10) d'un oscillateur est analysée comme mesure de l'éloignement d'une cible,
dans lequel, par comparaison de l'impédance (Z) du circuit oscillant (10) avec au moins un seuil à déterminer, un signal de commutation est produit et délivré,
et dans lequel, en plus, la fréquence de l'oscillateur est mesurée, afin de lever des ambiguïtés au niveau de l'analyse de l'impédance (Z) du circuit oscillant (10),
***caractérisé***
***en ce que*** l'amplificateur d'oscillateur est commuté entre deux amplifications définies précisément, et
***en ce qu***'après la commutation, un état oscillatoire respectif de l'oscillateur est évalué.

8. Procédé selon la revendication 7,
***caractérisé***
***en ce* qu'**un signal de commutation est délivré lorsque l'impédance (Z) passe au-dessous d'un seuil inférieur (90) ou au-dessus d'un seuil supérieur (80).

9. Procédé selon l'une quelconque des revendications 7 ou 8,
***caractérisé***
***en ce que*** le seuil inférieur (90) et/ou le seuil supérieur (80) est/sont déterminé(s) par des opérations d'apprentissage.

10. Procédé selon l'une quelconque des revendications 7 à 9,
***caractérisé***
***en ce* qu'**un amplificateur régulé en tension est utilisé comme amplificateur (16) d'oscillateur.

11. Procédé selon l'une quelconque des revendications 7 à 10,
***caractérisé***
***en ce qu*'**une amplification à régler de façon variable de l'amplificateur (16) d'oscillateur est utilisée pour compenser des variations de température de la distance de commutation (d).

12. Procédé selon l'une quelconque des revendications 7 à 11,
***caractérisé***
***en ce que*** les étapes de traitement suivantes sont effectuées successivement :
a) mesure de l'amplitude d'oscillation pour une première amplification (S2) ;
b) application du signal de commutation si l'oscillateur n'oscille pas à la première amplification (S10) et retour à l'étape a) ;
c) mesure de la fréquence d'oscillateur si l'oscillateur oscille à la première amplification (S4) ;
d) application du signal de commutation si la fréquence mesurée se trouve dans une plage de fréquences à déterminer (S10) et retour à l'étape a) ;
e) mesure de l'amplitude d'oscillation pour une deuxième amplification si la fréquence mesurée n'est pas comprise dans la plage de fréquences à déterminer (S6) ;
f) application du signal de commutation si l'oscillateur oscille à la deuxième amplification (S9) et retour à l'étape c) ; et
g) retour à l'étape a) si l'oscillateur n'oscille pas à la deuxième amplification (s8).
